(19) **Europäisches Patentamt** / **European Patent Office** / **Office européen des brevets**

(11) **EP 3 230 497 B1**

(12) **FASCICULE DE BREVET EUROPEEN**

(45) Date de publication et mention
de la délivrance du brevet:
**21.08.2019 Bulletin 2019/34**

(21) Numéro de dépôt: **15817125.6**

(22) Date de dépôt: **11.12.2015**

(51) Int Cl.:
***C30B 28/06*** *(2006.01)*    ***C30B 11/14*** *(2006.01)*
***C30B 29/06*** *(2006.01)*

(86) Numéro de dépôt international:
**PCT/EP2015/079482**

(87) Numéro de publication internationale:
**WO 2016/092093 (16.06.2016 Gazette 2016/24)**

(54) **PAVAGE DE GERMES UTILISÉS DANS UN CREUSET POUR LA SOLIDIFICATION DIRIGÉE DE SILICIUM COMPORTANT DES GERMES DÉSORIENTÉS VIS À VIS DU GERME ADJACENT**

ANORDNUNG VON EINKRISTALLKEIMEN MIT ABWEICHENDER ORIENTIERUNG VOM BENACHBARTEN KEIM FÜR GERICHTETES ERSTARREN DER SILIZIUMSCHMELZE IM BEHÄLTER

DISPOSITION OF SEEDS BEING DISORIENTATED FROM THE ADJACENT SEED FOR USE IN A CRUCIBLE FOR DIRECTIONAL SOLIDIFICATION OF SILICON

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.12.2014 FR 1462299**

(43) Date de publication de la demande:
**18.10.2017 Bulletin 2017/42**

(73) Titulaire: **Commissariat à l'Énergie Atomique et aux Énergies Alternatives**
**75015 Paris (FR)**

(72) Inventeurs:
- **PIHAN, Etienne**
  **73290 La Motte Servolex (FR)**
- **GARANDET, Jean-Paul**
  **92210 Saint-Cloud (FR)**
- **PLASSAT, Nelly**
  **73160 Vimines (FR)**

(74) Mandataire: **Nony**
**11 rue Saint-Georges**
**75009 Paris (FR)**

(56) Documents cités:
DE-A1-102011 075 093    DE-A1-102011 086 669
DE-A1-102012 102 597    FR-A1- 3 005 967
GB-A- 2 502 102          US-A1- 2007 169 685

US-A1- 2009 047 203    US-A1- 2013 233 239

- KUTSUKAKE KENTARO ET AL: "Influence of structural imperfection of[Sigma]5 grain boundaries in bulk multicrystalline Si on their electrical activities", JOURNAL OF APPLIED PHYSICS, AMERICAN INSTITUTE OF PHYSICS, US, vol. 101, no. 6, 19 mars 2007 (2007-03-19), pages 63509-063509, XP012098025, ISSN: 0021-8979, DOI: 10.1063/1.2710348
- Lejcek ET AL: "Chapter 2 Grain Boundaries: Description, Structure and Thermodynamics", Grain Boundary Segregation in Metals, 1 janvier 2010 (2010-01-01), XP055260857, ISBN: 978-3-642-12504-1 Extrait de l'Internet: URL:http://www.springer.com/cda/content/do cument/cda_downloaddocument/978364212504 1- c2.pdf?SGWID=0-0-45-968844-p173993259 [extrait le 2016-03-24]
- SUTATCH RATANAPHAN ET AL: "The five parameter grain boundary character distribution of polycrystalline silicon", JOURNAL OF MATERIALS SCIENCE, vol. 49, no. 14, 1 juillet 2014 (2014-07-01), pages 4938-4945, XP055259407, Dordrecht ISSN: 0022-2461, DOI: 10.1007/s10853-014-8195-2

## Description

La présente invention se rapporte à un procédé de préparation d'un assemblage de monocristaux de silicium, notamment sous la forme d'un pavage de germes destiné à la solidification dirigée d'un lingot de silicium. En particulier, un tel lingot peut être avantageusement découpé en plaquettes utiles pour l'industrie photovoltaïque.

Pour produire des plaquettes de silicium adaptées aux applications photovoltaïques, on met généralement en oeuvre un procédé de solidification dirigée par reprise sur germes, dit procédé « mono-like ».

Dans le cas d'un procédé de solidification dirigée par reprise sur germes, dit « mono-like », des germes de silicium monocristallin de forme pavé droit sont disposés au fond d'un creuset et forment un pavage. Par contact du silicium en fusion avec les germes, des grains croissent selon une direction privilégiée de solidification, et présentent sensiblement la même orientation cristallographique que les germes dont ils sont issus. Le lingot de silicium obtenu par ce procédé présente généralement des grains colonnaires qui s'étendent sur toute la hauteur du lingot.

Toutefois, la préparation du pavage de germes est une opération longue et délicate à mettre en oeuvre. En effet, les germes sont placés précautionneusement et manuellement au fond du creuset de solidification. L'attention portée à cette étape est importante pour limiter le développement de dislocations, qui dégradent les propriétés électriques du silicium lors de la solidification et du refroidissement du lingot.

Par ailleurs, il est industriellement difficile d'éviter le développement de contraintes thermomécaniques hétérogènes au sein du lingot au cours de sa solidification dirigée et de son refroidissement, qui entraînent la formation de zones à haute densité de dislocations. Pour limiter l'apparition de zones à haute densité de dislocations, des solutions industriellement complexes et coûteuses à mettre en oeuvre sont préconisées, consistant à améliorer l'isolation thermique du creuset et/ou à modifier fréquemment les conditions thermiques du four au fur et à mesure de la solidification et du refroidissement du lingot.

Il est aussi possible, comme décrit dans DE 10 2011 086669 A1 d'adapter spécifiquement le positionnement des germes relativement les uns aux autres.

Dans l'article « Influence ofstructural imperfection of Σ5 grain boundaries in bulk multicrystalline Si on their electrical activities », K. Kutsukake et al., Journal of Applied Physics, 101, 063509 (2007), il est décrit l'influence d'un joint d'indice de coïncidence (310)Σ5, connu pour être un joint de faible énergie, sur les propriétés électriques d'un assemblage alterné de monocristaux.

Dans le cadre de la fabrication par procédé de Czochralski d'un lingot de silicium monocristallin, Dash a décrit une méthode pour éliminer les dislocations en début de tirage [Dash]. Pour cela, la largeur du barreau initial, duquel le lingot est tiré, doit être inférieure à 10 mm, et la vitesse de tirage du lingot doit être supérieure à 100 millimètres par heure. De telles conditions de procédé ne peuvent être mises en oeuvre dans le cadre de la fabrication d'un lingot dit mono-like (c'est-à-dire réalisé par solidification dirigée à partir d'un germe), ni en terme de vitesse de croissance, ni en terme de dimension de lingot.

Il existe donc un besoin pour un lingot de silicium polycristallin dans lequel la quantité de plaquettes utiles pour applications photovoltaïques qui peut y être découpée est supérieure à celle qui peut être découpée dans un lingot mono-like de mêmes dimensions. Il existe aussi un besoin pour un procédé de fabrication d'un tel lingot.

La présente invention vise à satisfaire ce besoin, et elle y parvient notamment grâce à un assemblage organisé de monocristaux de silicium adjacents configuré pour la solidification dirigée d'un lingot selon une direction Z privilégiée de solidification, avec plus de 70 % en nombre des monocristaux de l'assemblage, dits « monocristaux orientés », observés sur une section perpendiculaire à la direction Z privilégiée de solidification étant tels que:

> a) la désorientation d'un monocristal orienté avec le ou les monocristaux orientés qui lui sont adjacents est supérieure à 8°,
> b) le plus petit des angles entre une normale au joint séparant un monocristal orienté d'un ou des monocristaux orientés adjacents et les directions <111> du ou des monocristaux orientés adjacents est supérieur à 4°,
> c) le plus petit des angles entre la direction de solidification Z, et les directions <100> dudit monocristal orienté est inférieur à 25° et/ou le plus petit des angles entre la direction Z privilégiée de solidification et les directions <111> du monocristal orienté est inférieur à 10°, et
> d) la distance de projection li dans un plan perpendiculaire à la direction Z privilégiée de solidification, de la plus grande dimension di du monocristal orienté, mesurée parmi les plans {111} et suivant les directions <110>, est inférieure à 40 mm, de préférence inférieure à 25 mm, de préférence inférieure à 20 mm, voire de préférence inférieure à 10 mm. Les monocristaux orientés étant en outre tels que le joint séparant un monocristal orienté d'un ou des monocristaux orientés adjacents est différent d'un joint proche d'un joint d'indice de coïncidence Σn, avec n choisi parmi les nombres 3, 5, 9, 11, 27, 51 et 59.

L'assemblage de monocristaux orientés de silicium selon l'invention peut être disposé au fond d'un creuset et la solidification dirigée d'un lingot par reprise sur l'assemblage de monocristaux peut être mise en oeuvre. De manière surprenante, les inventeurs ont constaté qu'un lingot obtenu à partir de l'assemblage selon l'invention comporte moins de zones à haute densité de dislocations qu'un lingot mono-like de mêmes dimensions, même si ledit lingot selon l'invention peut présenter plus de joints de grains qu'un lingot mono-like. Le volume du lingot disponible pour la découpe de plaquettes pour applications photovoltaïques s'en trouve augmenté. Il est ainsi possible de découper des plaquettes dont les dimensions ne sont pas limitées par la présence de zones à haute densité de dislocations.

Les inventeurs attribuent ces propriétés avantageuses à la réduction de la densité de dislocations procurée par la spécificité des orientations des monocristaux, des relations d'orientation entre les monocristaux adjacents, et aux dimensions des monocristaux selon les critères a) à d) décrits ci-dessus. En particulier, lors de la solidification et du refroidissement d'un lingot obtenu par reprise sur l'assemblage selon l'invention, les joints entre les grains adjacents du lingot agissent non pas comme des sources de dislocations, mais au contraire comme des zones où les dislocations présentes dans les grains sont confinées et peuvent potentiellement s'annihiler.

Un « monocristal de silicium » est de préférence tel que la teneur en masse en silicium qui le compose est supérieure à 99,99 %.

L'assemblage de monocristaux selon l'invention peut comporter des monocristaux autres que les « monocristaux orientés ». De tels monocristaux, qualifiés « d'orientation aléatoire » par la suite, bien qu'ils présentent individuellement tous une orientation particulière relativement à un repère fixe, ne sont pas considérés comme « orientés », car ils ne remplissent pas les critères a) à d) décrites ci-dessus.

Avantageusement, plus de 80 %, voire plus de 90 %, voire plus de 95 %, voire plus de 99 % en nombre, voire tous les monocristaux de l'assemblage peuvent être des monocristaux orientés.

La teneur en nombre de monocristaux orientés correspond au rapport du nombre de monocristaux orientés sur le nombre total de monocristaux observés sur une section perpendiculaire à la direction de solidification. De préférence, la teneur en nombre de monocristaux orientés correspond au rapport du nombre de monocristaux orientés sur le nombre total de monocristaux observés sur au moins deux, voire sur au moins cinq sections perpendiculaires à la direction de solidification, les dites sections étant réparties régulièrement selon la direction de solidification.

Une relation de désorientation entre les réseaux cristallins de deux monocristaux se traduit par une opération de rotation autour d'un axe de rotation d'indices cristallographiques <uvw> et d'un angle de rotation, qui permet de mettre en concordance la maille élémentaire d'un cristal de silicium du premier monocristal et la maille élémentaire du silicium du deuxième monocristal. La structure cristalline du silicium présentant 24 symétries cristallines connues, il existe un nombre fini de couples axe de rotation et d'angle de rotation pour effectuer la mise en concordance précitée. Par la suite, et sauf indication contraire, on nommera « désorientation», l'angle de rotation $\theta_d$ le plus petit parmi tous les angles des opérations de rotation précitées ; et on nommera « axe de désorientation », l'axe de rotation associé à cet angle de rotation.

Un « monocristal » est tel qu'en volume, plus de 95 %, voire plus de 99 %, voire la totalité du cristal qui le constitue présente une orientation cristalline sensiblement identique. Par exemple, mesurée par la méthode EBSD (« *Electron Back Scattered Diffraction* » en anglais) sur une surface du monocristal, la désorientation moyenne d'un ensemble constitué d'au moins dix couples de points répartis sous la forme d'un quadrillage à la surface du monocristal est inférieure à 0,5°.

Généralement, un monocristal est monolithique. En variante, un grain d'un lingot ou d'une plaque lié cohésivement à un grain adjacent peut constituer un monocristal.

Un «joint» de germe correspond à l'interface séparant deux monocristaux adjacents. Dans le cas où les germes sont des grains cohésifs, la surface de séparation correspond à un joint de grain. Dans le cas où les monocristaux forment des germes disjoints, le joint de germe peut être défini par la surface équidistante des faces des deux germes en regard.

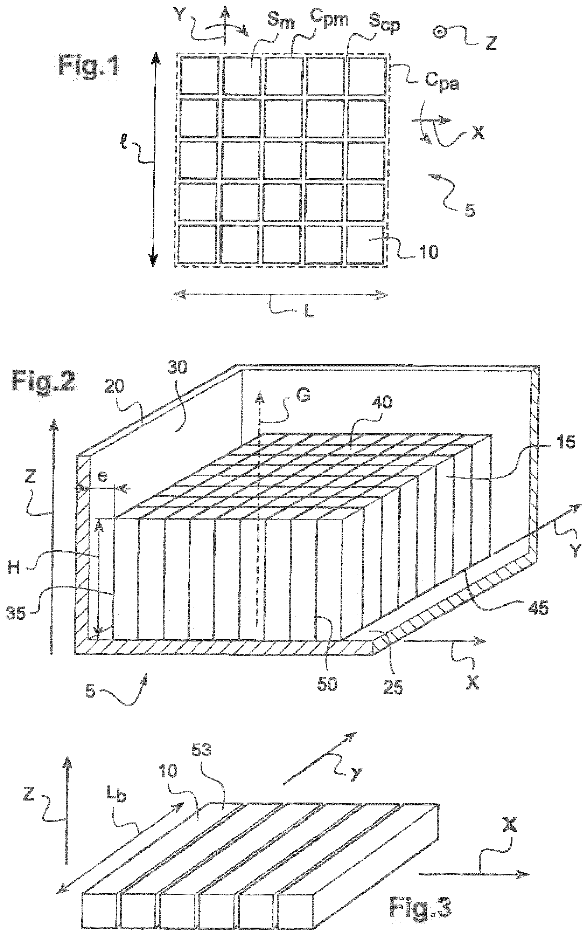

Un assemblage « organisé » de monocristaux est tel que les monocristaux qui le constituent sont disposés les uns par rapport aux autres de façon à limiter l'espace libre au sein de l'assemblage. En particulier, comme cela peut être observé sur la figure 1, lorsqu'observé selon une coupe transversale à la direction privilégiée de solidification Z, le rapport entre la surface $S_m$ occupée par les monocristaux sur la surface $S_{cp}$ définie par le contour périphérique de l'assemblage (représenté en pointillés sur la figure 1) est supérieur à 90 %, de préférence supérieur à 95 %, voire supérieur à 99 %.

La « direction privilégiée de solidification » est, parmi l'ensemble des directions de solidification pour lesquelles un lingot peut être obtenu à partir de l'assemblage selon l'invention, celle pour laquelle le lingot présente, pour une hauteur donnée, un nombre de grains sensiblement égal au nombre de monocristaux de l'assemblage à partir duquel il a crû, et un volume de silicium maximal par grain. Par souci de clarté, par la suite et sauf indication contraire, une direction de solidification désigne spécifiquement la direction privilégiée de solidification.

Un plan « transversal » à une direction est perpendiculaire à cette direction.

L'invention concerne aussi un procédé de solidification dirigée, comportant les étapes successives suivantes :

i) placer un assemblage de monocristaux selon l'une quelconque des revendications précédentes sur le fond de la cavité destinée à recevoir du silicium en fusion d'un creuset,

ii) procéder à la solidification dirigée de silicium par reprise sur germes selon une direction Z privilégiée de solidification normale à l'assemblage de monocristaux de façon à obtenir un lingot de silicium,

iii) optionnellement, débiter le lingot en briques de section équivalente à la dimension souhaitée des plaquettes puis scier les briques en plaquettes de 50 à 300 μm d'épaisseur et/ou

découper le lingot ou une partie du lingot obtenu à l'étape ii) ou au moins une des briques selon une direction normale à la direction privilégiée de solidification du lingot de façon à obtenir une plaque ou un ensemble de plaques, de préférence d'épaisseur comprise entre 5 et 60 mm,

iv) optionnellement, reprendre le procédé à l'étape i), l'assemblage de monocristaux étant formé par la plaque ou l'ensemble de plaques obtenue(s) à l'étape iii).

Elle concerne aussi un lingot de silicium obtenu par le procédé selon l'invention, dans lequel de préférence plus de 70 % en nombre des grains du lingot, dits « grains orientés », observés sur une section perpendiculaire à la direction Z privilégiée de solidification sont tels que:

a) la désorientation $\theta_d$ d'un grain orienté avec le ou les grains orientés qui lui sont adjacents est supérieure à 8°,

b) le plus petit $\alpha$ des angles entre une normale au joint séparant un grain orienté d'un ou des grains orientés adjacents et les directions <111> du ou des grains orientés adjacents est supérieur à 4°,

c) le plus petit $\beta$ des angles entre la direction Z privilégiée de solidification et les directions <100> dudit grain orienté est inférieur à 25° et/ou le plus petit des angles entre la direction Z privilégiée de solidification et les directions <111> du grain orienté est inférieur à 10°, et

d) la distance de projection $l_i'$ dans un plan perpendiculaire à la direction Z privilégiée de solidification, de la plus grande dimension $d_i$ du grain orienté, mesurée parmi les plans {111} et suivant les directions <110>, est inférieure à 40 mm, de préférence inférieure à 25 mm, de préférence inférieure à 20 mm, de préférence inférieure à 10 mm.

De préférence, le lingot présente une hauteur, mesurée selon la direction privilégiée de solidification, d'au moins 100 mm.

L'invention concerne enfin un ensemble comportant un assemblage selon l'invention et un creuset utile pour la solidification dirigée par reprise d'un lingot de silicium, ledit creuset comportant un logement, destiné à recevoir du silicium en fusion, dont le fond est recouvert en tout ou partie par l'assemblage selon l'invention.

D'autres caractéristiques et avantages ressortiront mieux à la lecture de la description détaillée qui va suivre, de l'exemple de réalisation de l'invention et à l'examen des dessins annexés, sur lesquels :

- la figure 1 illustre sous une forme éclatée et selon la direction de solidification, un assemblage de monocristaux sous la forme d'un pavage de germes ; autrement dit, les distances séparant les germes adjacents ont été exagérées ;
- la figure 2 illustre un assemblage de monocristaux orientés selon l'invention sous la forme d'un bloc monolithique, disposé sur le fond d'un creuset, le creuset étant représenté en coupe et en écorché ;
- la figure 3 illustre une variante de réalisation d'un assemblage selon l'invention ;
- la figure 4 représente deux monocristaux orientés dont les réseaux cristallins sont désorientés d'un angle $\theta$ ;
- la figure 5 illustre deux monocristaux orientés séparés par un joint de torsion ;
- la figure 6 illustre le critère c) d'un assemblage selon l'invention ;
- la figure 7 illustre la méthode de détermination de la distance $l_i$ ; et
- la figure 8 représente en coupe un lingot de silicium en cours de solidification par reprise sur un assemblage selon l'invention.

Il convient de noter que, pour des raisons de clarté, les différents éléments sur les figures sont représentés en échelle libre, les dimensions réelles des différentes parties n'étant pas respectées.

Dans la suite du texte, l'expression « compris entre ... et ... », signifie que les bornes sont incluses, sauf mention contraire.

Sauf indication contraire, l'expression « comportant/comprenant un(e) » doit être comprise comme « comportant/comprenant au moins un(e) ».

## Assemblage de monocristaux

Comme cela sera apparent par la suite, l'assemblage 5 selon l'invention peut être monobloc, c'est-à-dire monolithique, ou au contraire multi-blocs. Plus particulièrement, il peut se présenter sous la forme d'un pavage de germes, comme illustré sur la figure 1. Le cas échéant, au moins un, de préférence chaque germe 10 du pavage est défini par un monocristal de l'assemblage et est amovible. Autrement dit, il est possible de retirer un germe du pavage, par exemple manuellement, sans modifier l'agencement des germes restants au sein du pavage. L'intégrité structurelle de l'assemblage sous forme d'un pavage est notamment assurée que par le fait que le pavage est disposé sur un support, par exemple sur le fond d'un creuset.

En variante, l'assemblage 5 selon l'invention peut aussi se présenter sous la forme d'un bloc monolithique constitué de grains 15, comme cela est illustré sur la figure 2. Le cas échéant, au moins un, de préférence chaque grain du bloc est formé par un monocristal de l'assemblage, et est lié cohésivement aux grains qui lui sont adjacents. L'assemblage sous forme d'un bloc monolithique est suffisamment rigide pour ne pas rompre sous son propre poids.

Qu'il soit monobloc ou multi-blocs, l'assemblage peut présenter une forme de pavé droit dont la hauteur, mesurée selon la direction de solidification Z, est comprise entre 5 et 100 mm. Dans un mode de réalisation de l'invention, la hauteur peut être inférieure à 30 mm et l'assemblage peut alors être désigné en tant que plaque lorsqu'il est monolithique et en tant que pavage lorsqu'il est multi-blocs.

De préférence, en coupe selon un plan transversal à la direction de solidification, le contour périphérique $C_{pa}$ de l'assemblage est de forme quasi-rectangulaire, comme cela peut être observé sur la figure 1. De préférence, les largeurs l et longueur L du contour périphérique sont supérieures à 300 mm. Le contour périphérique peut aussi être de forme carré, de préférence supérieur à 300mm.

Notamment, les largeur et longueur du contour périphérique peuvent être chacun un multiple entier de 156 mm additionné d'une dimension d'éboutage de 20 mm en périphéries.

L'assemblage selon l'invention peut notamment être disposé sur le fond d'un creuset 20 d'axe Z utile pour la solidification dirigée, comme cela est observé sur la figure 3. Il peut être formé au fond d'un creuset classique. On peut aussi envisager un creuset dont le fond lui-même est formé de l'assemblage selon l'invention.

De préférence, l'assemblage recouvre la totalité de la surface du fond 25 du creuset (par exemple, dans le cas d'un creuset en graphite) ou la quasi-totalité de la surface du fond du creuset (par exemple, dans le cas d'un creuset qui peut être sujet à un retrait, par exemple de 2 %, tel que les creusets en silice. Selon une variante de l'invention, il subsiste une surface au fond du creuset non couverte par les germes). En particulier, la distance e entre une paroi latérale 30 du creuset (c'est-à-dire s'étendant notamment selon la direction de solidification) en regard d'une face latérale 35 d'un germe situé à la périphérie du pavage, est de préférence inférieure à 50 mm.

Comme cela est illustré sur la figure 2, l'enveloppe externe de l'assemblage peut définir deux faces terminales 40,45, orthogonales à la direction de solidification Z, séparées selon la hauteur H de l'assemblage. Ces deux faces terminales sont avantageusement planes.

Dans les variantes où l'assemblage forme un pavage de germes ou forme une plaque, la hauteur d'un monocristal orienté peut être comprise entre 5 mm et 100 mm.

De préférence, les monocristaux orientés de l'assemblage s'étendent entièrement entre les deux faces terminales 40,45 de l'assemblage. De préférence, la hauteur d'un monocristal orienté, mesurée selon la direction de solidification Z, est égale à la hauteur de l'assemblage. De préférence, ils présentent une forme prismatique, dont la génératrice G est parallèle à la direction de solidification. De préférence encore, les monocristaux orientés présentent une forme de pavé droit.

Dans le mode de réalisation illustré sur la figure 3, l'assemblage est constitué de monocristaux 10 présentant une forme de barreaux 53 disposés unidirectionnellement, selon la direction X, les uns par rapport aux autres et de manière contiguë. Les barreaux présentent des axes longitudinaux, de préférence non confondus, orthogonaux à la direction de solidification, parallèles les uns aux autres. De préférence, la longueur $L_b$ du barreau, mesurée selon la direction longitudinale, est supérieure à 300 mm. De préférence, la longueur du barreau est choisie de façon à ce qu'une fois disposé dans un creuset, l'écart entre la distance entre deux parois opposées entre lesquelles s'étend le barreau et la longueur du barreau est inférieure à 100 mm. En particulier, dans le cas où l'assemblage de monocristaux est sous forme d'un pavage de germes, la réalisation d'un pavage de germes à l'aide de tels barreaux s'en trouve facilitée, le nombre de germes pour paver une surface d'aire fixée est réduite La largeur du barreau est de préférence inférieure à 20 mm.

Dans une variante par exemple illustrée sur la figure 1, les monocristaux orientés présentent une section transversale carrée, de préférence de côté inférieur ou égal à 20 mm.

Ils sont disposés selon deux directions X et Y orthogonales et présentent des arêtes parallèles aux directions X ou Y. Les directions X et Y sont de préférence perpendiculaires à la direction de solidification Z.

En particulier, observés sur une section transverse à la direction de solidification, les monocristaux orientés peuvent définir un quadrillage, de préférence périodique selon les directions X et Y. Par ailleurs, les monocristaux orientés sont disposés de manière contiguë au sein de l'assemblage.

Comme décrit ci-dessus, les monocristaux orientés peuvent être cohésifs et liés les uns aux autres. Ils peuvent alors définir des grains d'un bloc monolithique. La frontière entre deux monocristaux orientés est alors définie par un joint de grain 50.

En variante, les monocristaux orientés peuvent être disjoints les uns des autres. Ils peuvent alors définir les germes d'un pavage de germe. De préférence, deux germes adjacents sont au contact l'un de l'autre. Ils peuvent toutefois être espacés et la distance maximale entre les deux faces latérales en regard des germes adjacents est alors de préférence inférieure à 2 mm.

De préférence, dans la variante où le pavage est formé de germes ayant la forme et la disposition de barreaux tels qu'illustrés sur la figure 3, disposés unidirectionnellement selon un axe X perpendiculaire aux directions longitudinales Y des barreaux, le pavage de germes est formé à partir de germes identiques. Deux germes adjacents et alignés suivant la direction X peuvent alors être images l'un de l'autre par retournement à 180° d'axe Y.

De préférence, dans la variante où le pavage est formé de germes disposés selon des directions X et Y orthogonales comme décrit ci-dessus, le pavage peut être réalisé à partir de germes identiques avec deux germes adjacents et alignés suivant la direction X étant images l'un de l'autre par un retournement d'axe Y et deux germes adjacents et alignés selon la direction Y étant images l'un de l'autre par un retournement d'axe X.

En particulier, les germes identiques peuvent être issus même d'un lingot de silicium élaboré selon une technique de tirage Czochralski (encore appelé lingot « *Cz* »), technique dans laquelle un germe mono-cristallin de silicium est mis en contact avec un bain de silicium en fusion, afin de faire croître un lingot monocristallin.

Cette méthode fournit généralement des lingots Cz de forme cylindrique. Ils peuvent être usinés, de manière conventionnelle et découpés par exemple en tranches perpendiculaires à l'axe ($Z_c$) du cylindre pour obtenir des germes de forme pavé droit.

Le tirage donne un lingot de silicium avec un plan cristallographique perpendiculaire à l'axe ($Z_c$) du lingot et déterminé par l'orientation cristalline du germe (par exemple <100>).

Il est alors possible d'usiner des germes avec une orientation spécifiques du réseau cristallin souhaitée, par exemple par découpe du lingot Cz avec une rotation autour de l'axe du cylindre ($Z_c$).

## Monocristaux orientés

Les monocristaux orientés au sein de l'assemblage selon l'invention sont disposés spécifiquement les uns par rapport aux autres.

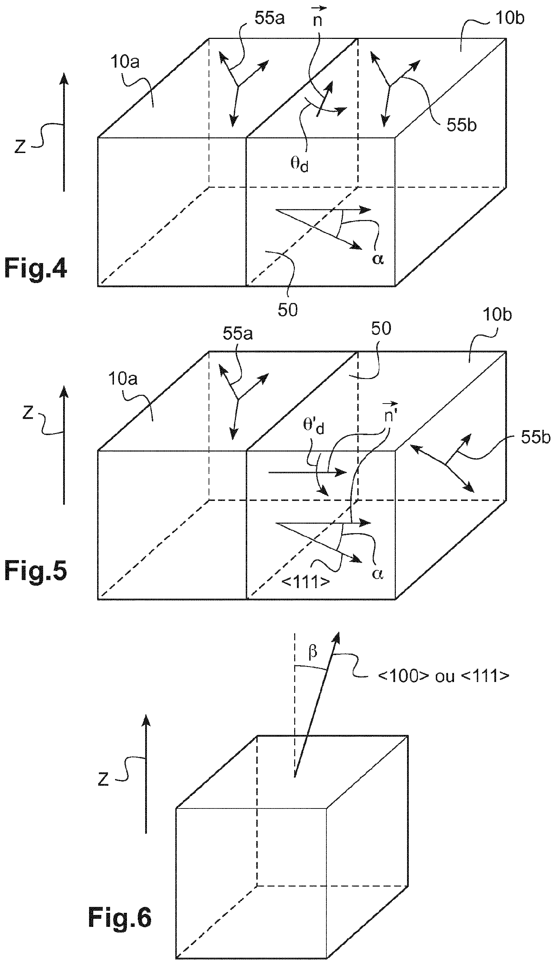

La figure 4 illustre, en vue selon une direction parallèle à la direction de solidification une configuration de monocristaux orientés selon l'invention.

Des premier 10a et deuxième 10b monocristaux orientés représentés sur cette figure présentent chacun une forme de pavé droit et des orientations cristallographiques distinctes. Les trièdres 55a,55b représentés dans chacun des monocristaux orientés illustrent les orientations des axes <100> du cristal de silicium au sein de chaque monocristal orienté.

Comme cela apparait sur cette figure, il est possible de faire concorder les axes du trièdre du cristal du premier monocristal orienté avec ceux du cristal du deuxième monocristal orienté en effectuant une rotation d'angle de désorientation $\theta_d$ autour d'un vecteur de désorientation $\vec{n}$.

Selon le critère a) défini ci-dessus, la désorientation d'un monocristal orienté avec le ou les monocristaux qui lui sont adjacents est supérieure à 8°. Les premier et deuxième monocristaux orientés sont séparés par un joint 50. Dans le cas où les monocristaux forment des grains liés cohésivement de l'assemblage monolithique, le joint entre deux monocristaux est un joint de grain. Dans le cas où les monocristaux sont disjoints les uns des autres, le joint est alors défini comme la surface médiane aux deux monocristaux adjacents. Cette surface médiane est située à mi-distance des faces en regard des monocristaux adjacents. Lorsque les faces des monocristaux adjacents sont planes, la surface médiane est alors un plan médian.

Dans un premier mode de réalisation, illustré par exemple sur la figure 4, le joint entre les monocristaux est un joint symétrique. Un joint symétrique définit un plan de symétrie cristalline pour les réseaux cristallins situés de part et d'autre de ce plan. Un joint symétrique est nécessairement un joint de flexion i.e. un joint de flexion est tel que la rotation d'angle de désorientation $\theta_d$ et d'axe $\vec{n}$ pour mettre en concordance les réseaux cristallins de deux monocristaux adjacents est telle que l'axe $\vec{n}$ est colinéaire à l'axe de croissance du cristal et compris dans le plan de joint. La symétrie d'un joint de grain de flexion symétrique est définie par rapport à un plan dense du réseau cristallin (hkl). Le joint de flexion est symétrique lorsque l'un des cristaux est tourné de d'un angle $-\theta_d/2$, l'autre d'un angle $+ \theta_d/2$ par rapport au plan de de joint.

Dans une variante, illustrée par exemple sur la figure 5, le joint entre deux monocristaux orientés adjacent peut être un joint de torsion. Un joint de torsion est tel que le vecteur $\vec{n'}$ autour duquel s'effectue la rotation d'angle de désorientation $\theta'_d$ pour faire coïncider les réseaux cristallins des deux monocristaux orientés adjacents est normal au plan définissant le joint de grain. De préférence, le joint de torsion est de type {100}, c'est-à-dire qu'un axe <100> des monocristaux séparés par un joint, est normal audit joint, et la désorientation entre les deux monocristaux orientés adjacents est supérieure à 8°. Dans une autre variante préférée, le joint de torsion est de type {110}, c'est-à-dire dont un axe <110> du cristal est normal au plan définissant le joint, et la désorientation entre les deux monocristaux orientés adjacents est supérieure à 8°.

Par ailleurs, selon le critère b) défini ci-dessus, le plus petit $\alpha$ des angles entre une normale au joint séparant un monocristal orienté d'un ou des monocristaux adjacents et les directions <111> du ou des monocristaux adjacents est supérieure à 4°.

Une disposition respectant les critères a) et b) est notamment illustrée sur la figure 4.

De préférence, les monocristaux orientés sont tels que le joint séparant un monocristal orienté d'un ou des monocristaux orientés adjacents est différent d'un joint proche d'un joint d'indice de coïncidence $\sum n$, avec $n$ choisi parmi les nombres 3, 5, 9, 11, 27, 51 et 59. Un joint séparant deux monocristaux orientés présentant une désorientation et un angle $\alpha$ tels que selon les critères a) et b) et qui est différent d'un joint proche d'un joint d'indice de coïncidence $\sum n$ tel que décrit ci-dessus, est qualifié de joint de haute énergie. Comme cela sera décrit par la suite, un joint de haute énergie est particulièrement bien adapté à un assemblage selon l'invention, notamment lorsque celui-ci est mis en oeuvre pour la solidification d'un lingot.

Un joint présentant un indice de coïncidence $\sum n$ est bien connu de l'homme du métier. Les joints proches des joints d'indice de coïncidence $\sum 3$, $\sum 5$, $\sum 9$, $\sum 11$, $\sum 27$, $\sum 51$ et $\sum 59$ sont connus pour être des joints de faible énergie.

Par « joint proche d'un joint d'indice de coïncidence $\sum n$ », on considère ledit joint d'indice de coïncidence $\sum n$ ainsi que tout joint présentant un plan de joint désorienté du plan dudit joint d'indice de coïncidence $\sum n$ par une désorientation inférieure à 1° en valeur absolue, et étant tel que la différence entre la désorientation entre les deux monocristaux adjacents que le joint sépare d'une part, et la désorientation du joint d'indice de coïncidence $\sum n$ d'autre part, est inférieure à 2° en valeur absolue.

Par ailleurs, selon le critère c) défini ci-dessus et tel qu'illustré sur la figure 6, un monocristal orienté est tel que le plus petit $\beta$ des angles entre la direction de solidification Z, et les directions <100> du monocristal orienté est inférieur à 25° et/ou le plus petit des angles entre la direction de solidification Z et les directions <111> dudit monocristal orienté est inférieur à 10°.

De préférence, un monocristal orienté est tel que le plus petit $\beta$ des angles entre la direction de solidification Z, et les directions <100> dudit monocristal orienté est supérieur à 4°, de préférence est supérieur à 8°. Lors de la mise en oeuvre d'un assemblage présentant une telle valeur minimale d'angle $\beta$ pour la solidification d'un lingot, la propagation des dislocations est alors facilitée vers les joints de haute énergie séparant les grains du lingot, ce qui permet d'éviter leur propagation à l'interface solide/liquide sur toute la hauteur du lingot.

Un monocristal orienté de l'assemblage selon l'invention est aussi tel que la distance de projection $l_i$ dans un plan perpendiculaire à la direction Z, de la plus grande dimension $d_i$ du monocristal orienté, mesurée parmi les plans {111} et suivant les directions <110>, est inférieure à 40 mm, de préférence inférieure à 25 mm, de préférence inférieure à 20 mm, de préférence inférieure à 10 mm, de préférence encore inférieure à 5 mm.

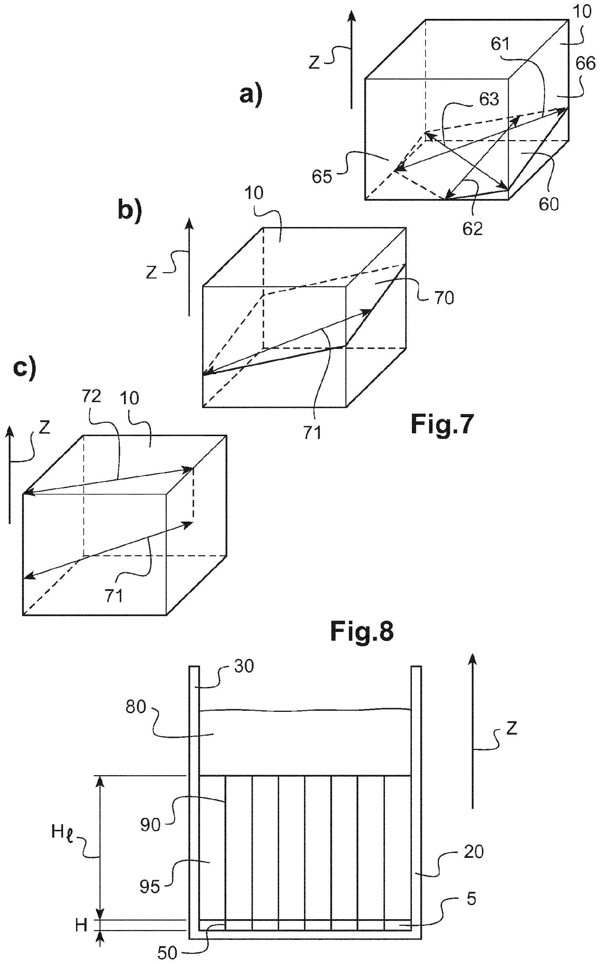

La détermination de la distance $l_i$ d'un monocristal orienté est détaillée à l'aide de la configuration illustrée sur la figure 7, sur laquelle un monocristal orienté de type pavé droit est représenté. Le monocristal orienté présente deux faces opposées dont des normales sont parallèles à la direction de solidification Z.

Sur la figure 7)a), on a illustré un premier 60 plan de type {111} du cristal de silicium qui coupe le monocristal orienté. Par exemple, ce plan de la famille {111} est un plan (111). Il contient les trois directions <110> du cristal cubique. Trois segments 61, 62, 63 sont représentés sur cette figure 1a). Le premier de ces trois segments présente une première extrémité définie par l'intersection d'une ligne parallèle à une direction [110] (de la famille de directions <110>) et une première face 65 du monocristal orienté. La deuxième extrémité est définie par l'intersection de ladite ligne et d'une deuxième face 66, qui tel qu'illustrée, est opposée à la première face. Ce segment présente une longueur d.

Parmi l'ensemble des directions <110> dudit plan (111), ce segment est celui qui présente la plus grande dimension $d_{110}$.

Les deuxième 62 et troisième 63 segments sont parallèles aux autres directions [011] et [101] respectives de la famille de directions <110>. Parmi l'ensemble des directions [011] et [101] contenues dans le plan (111), ces segments qui joignent deux faces opposées du monocristal orienté, sont ceux présentant les plus grandes dimensions $d_{[01\bar{1}]}$ et $d_{[10\bar{1}]}$.

On détermine alors pour ce premier plan (111) la plus grande dimension parmi les dimensions des segments $d_{[1\bar{1}0]}$, $d_{[01\bar{1}]}$ et $d_{[10\bar{1}]}$.

A titre illustratif, pour le plan représenté sur la figure 7) a), le segment de plus grande distance est selon la direction [110] .

Le processus de mesure du segment parallèle aux directions de type <110> et de longueur maximale, tel que décrit ci-dessus, est ensuite réitéré pour l'ensemble des plans (111) parallèles au premier plan (111). Par exemple, comme illustré sur la figure 7)b), sur un deuxième 70 plan cristallin de type (111) parallèle au premier 60 plan (111) illustré sur la figure 7)a), le segment 71 de plus grande distance est orienté selon une direction parallèle à la direction [1$\bar{1}$0]. Il présente une dimension $d'_{[1\bar{1}0]}$.

Ainsi, pour l'ensemble des plans (111) de la famille {111} dans l'exemple illustré, la plus grande dimension du cristal orienté est égale à $d'_{[1\bar{1}0]}$.

Le processus, tel qu'illustré sur les figures 7) a) et b), est ensuite réitéré pour les autres plans de la famille de plans de type {111}, de façon à déterminer pour l'ensemble des quatre plans de type {111} (en l'occurrence (111), (111), (111), (11$\bar{1}$)), le segment parallèle à une direction de type <110> et joignant deux faces du monocristal orienté de plus grande longueur $d_i$.

Parmi l'ensemble de tous les points de la famille {111} du monocristal orienté, la plus grande dimension du monocristal est de longueur $d_i$. Dans l'exemple illustratif de la figure 3, cette plus grande longueur $d_i$ est portée par le segment 71.

Ce segment 71 de longueur $d_i$ est finalement projeté sur une des faces du monocristal orienté de normale parallèle à la direction de solidification Z. Le segment projeté 72 présente une dimension $l_i$ inférieure ou égale à la distance $d_i$.

Le processus de détermination de la distance

$l_i$ peut être aisément déterminé à partir de la connaissance de l'orientation et des dimensions du monocristal orienté. Il peut avantageusement être mis en oeuvre par l'homme du métier à l'aide de moyens de calcul numérique.

Par ailleurs, un monocristal orienté selon l'invention présente une densité de dislocations inférieure à $10^5$ cm$^{-2}$.

## Formation d'un lingot de silicium

Pour fabriquer un lingot de silicium, dans une première étape de procédé, on place l'assemblage de monocristaux selon l'invention, tel que décrit ci-dessus, sur le fond 25 de la cavité destinée à recevoir du silicium en fusion d'un creuset comme illustré sur les figures 2 et 8.

On peut notamment disposer l'assemblage de monocristaux sous la forme d'un pavage de germes ou sous la forme d'une plaque monolithique tels que décrits ci-dessus.

Dans une seconde étape, on procède à la solidification dirigée de silicium par reprise sur l'assemblage 5 de monocristaux orientés selon l'invention selon une direction de solidification colinéaire à l'axe (Z).

L'homme du métier est à même d'ajuster les conditions opératoires pour l'élaboration du lingot de silicium par solidification dirigée.

La solidification dirigée peut être opérée dans un four conventionnel de solidification dirigée, comme par exemple dans un four de cristallisation de type HEM (provenant du nom anglais « *Heat Exchange Method* ») ou de type Bridgman avec un chauffage fixe par le haut et les côtés, qui permet de cristalliser la charge de silicium avec un gradient de température contrôlé.

D'une manière générale, la solidification dirigée est effectuée en faisant fondre, dans un premier temps, une charge de silicium dans le creuset dont le fond est revêtu de l'assemblage selon l'invention. Lorsque le silicium est complètement en fusion, et que l'assemblage de monocristaux commence à fondre, le silicium en fusion 80 est solidifié, de façon dirigée, à faible vitesse (typiquement de 5 à 30 mm/h).

La solidification dirigée peut être réalisée par déplacement du système de chauffage et/ou par refroidissement contrôlé, permettant un déplacement progressif du front de solidification (front de séparation entre la phase solide et la phase liquide) vers le haut du creuset.

Le lingot obtenu à l'issue de la solidification dirigé peut être ensuite refroidi, notamment jusqu'à température ambiante (20 °C $\pm$ 5 °C).

Comme décrit ci-dessus, les inventeurs ont constaté que la solidification dirigée d'un lingot à partir de l'assemblage de grains selon l'invention permet d'obtenir un lingot comportant une densité de joints de grains élevée mais dans lequel la densité moyenne de dislocations est particulièrement faible. Ils attribuent cette constatation à la synergie des orientations cristallographiques, dimensions des monocristaux orientés, et disposition particulière des monocristaux orientés les uns par rapport aux autres selon l'invention.

Au cours de la solidification dirigée d'un lingot de silicium à partir de l'assemblage selon l'invention, comme cela sera décrit ci-dessous, des grains du lingot vont croitre à partir des monocristaux orientés de l'assemblage en conservant l'orientation du monocristal orienté à partir duquel ils ont germé, et en particulier les relations d'orientations entre les directions <111>, <100> et/ou <111> et la direction de solidification Z décrite ci-dessus dans les critères b) et c) pour le monocristal orienté dont ils ont issus.

De manière avantageuse, comme représenté schématiquement sur la figure 8, les joints de grains 90 se propagent dans le lingot de silicium de manière contrôlée à partir des joints 50 entre les germes. De manière avantageuse, en particulier quand le joint de germe dont il est issu est un joint symétrique, le joint de grain se propage parallèlement à la direction de solidification. De préférence, il définit un plan qui contient la direction de solidification.

De préférence, les joints de grains du lingot présentent une désorientation entre les grains qu'ils séparent sensiblement identique à celle des joints entre monocristaux dont ils sont issus telle que définie par le critère a). Avantageusement, les dislocations qui se développent au cours de la croissance du lingot dans le voisinage du joint de grain ne peuvent se propager.

Par ailleurs, au cours de la solidification dirigée du lingot de silicium, la distance de projection $l_i'$ de la plus grande dimension d'un grain qui a crû à partir d'un monocristal orienté, mesurée parmi les plans {111} et suivant les directions <110> est inférieure à 40 mm, de préférence inférieure à 25 mm, de préférence inférieure à 20 mm, de préférence inférieure à 10 mm. La distance $l_i'$ peut être déterminée sur le lingot après refroidissement suivant la méthode précédemment décrit pour déterminer la distance $l_i$ du monocristal orienté. Avantageusement, le grain qui a crû selon la direction de solidification à partir d'un monocristal orienté présente une distance $l_i'$ comprise entre 0,8 et 1,2 fois, de préférence 0,9 à 1,1 fois, de préférence comprise entre 0,95 et 1,05 fois, de préférence sensiblement égale à la distance $l_i$ dudit monocristal orienté.

De préférence, au sein du lingot de silicium obtenu par le procédé selon l'invention la densité moyenne de dislocations, est inférieure à $10^6$ cm$^{-2}$ et/ou la densité de dislocations intra granulaires est inférieure à $10^5$ cm$^{-2}$.

En particulier, selon une coupe transversale normale à la direction Z, au moins 70 %, de préférence 80 %, de préférence 90 % en nombre, voire tous les grains orientés du lingot de silicium présentent une densité de dislocation intra-granulaire inférieure à $10^5$ cm$^{-2}$.

La densité moyenne de dislocations du lingot de silicium correspond au rapport de la somme des longueurs totales des dislocations contenues dans le lingot sur le volume du lingot. Les densités moyennes de dislocations peuvent être mesurées par exemple par topographie de rayon X ou par révélation chimique des dislocations à partir d'une surface polie et comptage.

Les inventeurs attribuent la faible densité de dislocations intra granulaires du lingot au fait qu'à une température supérieure à 1200 °C, une dislocation est mobile sur une distance au maximum égale à la longueur $l_i'$. Une dislocation, située à une distance inférieure à $l_i'$ d'un joint de grain de haute énergie, peut être mobile par glissement vers ce joint de grain de haute énergie du fait de l'attraction qu'il génère. De préférence, le respect du critère c) décrit ci-dessus assure qu'une telle dislocation est située sur un plan de glissement sur lequel elle est apte à glisser. Cette dislocation peut alors être annihilée par les dislocations situées au voisinage immédiat du joint de grain, ce qui permet de réduire la densité de dislocations à l'intérieur des grains. Au contraire, un joint de basse énergie tel qu'un joint proche d'un joint d'indice de coïncidence $\sum n$, avec $n$ choisi parmi les nombres 3, 5, 9, 11, 27, 51 et 59, n'est pas adapté. Notamment, lorsqu'un assemblage formé de monocristaux orientés séparés par de tels joints de faible énergie est mis en oeuvre pour la solidification d'un lingot, des sous-joints de grain se forment généralement au sein des grains du lingot, résultant en une diminution des propriétés électriques du lingot.

Comme cela apparait à présent, les grains du lingot respectent préférentiellement les critères a) à d) définis pour l'assemblage de monocristal. Avantageusement, le lingot obtenu par solidification dirigée à partir de l'assemblage de monocristaux orientés selon l'invention peut ainsi constituer lui aussi l'assemblage de monocristaux orientés selon l'invention, les monocristaux orientés étant liés entre eux et formant des grains orientés du lingot.

Il peut comporter des grains d'orientation aléatoire, c'est-à-dire qui ne présentent pas les critères a) à d) de l'assemblage selon l'invention.

De tels grains peuvent notamment avoir cru à partir des parois latérales 30 du creuset. Sur une coupe transversale du lingot perpendiculaire à la direction de solidification, la teneur de grains d'orientation aléatoire, exprimée en nombre de grains d'orientation aléatoire observés sur la coupe transversale, divisée par le nombre total de grains observés sur la coupe transversale, est de préférence inférieure à 30 %, de préférence inférieure à 20 %, de préférence inférieure à 10 %, inférieure à 5 %, voire même nulle.

Le procédé de fabrication d'un lingot peut comporter une étape iii), consistant à découper le lingot obtenu à l'étape ii) selon une direction normale à la direction de solidification du lingot de façon à obtenir une plaque.

De préférence, la plaque présente une épaisseur comprise entre 5 mm et 100 mm. Avantageusement, la plaque peut présenter des largeur et longueur, mesurées selon une direction normale à son épaisseur, qui sont chacune un multiple entier de 156 mm additionné d'une dimension d'éboutage de 20 mm en périphérie.

La plaque découpée présente des grandes faces, de préférence parallèles, séparées selon la hauteur de la plaque. De préférence, la plaque comporte des grains qui s'étendent entièrement selon hauteur entre les deux grandes faces.

La plaque étant issue d'un lingot formant assemblage de monocristaux selon l'invention, elle peut être découpée dans une zone du lingot de façon à former elle aussi l'assemblage de monocristaux selon l'invention.

La plaque est avantageusement monolithique, et suffisamment rigide pour ne pas rompre sous son propre poids.

De préférence, la densité moyenne de dislocations de la plaque est inférieure à $10^6$ cm$^{-2}$ et/ou la densité de dislocations intra granulaires est inférieure à $10^5$ cm$^{-2}$.

Une telle plaque peut alors être placée sur le fond de la cavité destinée à recevoir du silicium en fusion d'un creuset. Il est ainsi possible, selon une étape iv) du procédé selon l'invention, de fabriquer un nouveau lingot de silicium, en reprenant le procédé de fabrication à l'étape i) à l'aide de l'assemblage de monocristaux formé par la plaque obtenue à l'étape iii) décrite ci-dessus.

Le procédé selon l'invention présente ainsi de nombreux avantages.

Comme cela a été décrit ci-dessus, à partir d'un pavage de germes présentant les caractéristiques de l'assemblage de monocristaux selon l'invention, de faible hauteur H, un lingot de silicium d'une hauteur $H_l$ au moins dix fois supérieure à la hauteur H du pavage de germes peut être obtenu par solidification dirigée. Ce lingot présente avantageusement les caractéristiques de l'assemblage selon l'invention.

Il est alors envisageable de découper au moins un, de préférence au moins trois, voire au moins dix plaques présentant chacune une hauteur inférieure ou égale à 1,5 fois la hauteur du pavage de germes initial. Avantageusement, au moins une, de préférence toutes les plaques ainsi découpées présentent les caractéristiques de l'assemblage selon l'invention.

Une telle plaque monolithique peut alors être destinée à la fabrication d'un nouveau lingot pour la solidification dirigée par reprise en suivant l'étape a) du procédé selon l'invention, les grains de la plaque définissant alors des germes pour la reprise.

Avantageusement, à partir de l'assemblage de monocristaux selon l'invention sous la forme d'un pavage de germes, il est possible de préparer plusieurs plaques pour fabriquer de nouveaux lingots.

Une plaque obtenue par le procédé selon l'invention présente en outre l'avantage de pouvoir être aisément transportée et son utilisation en fond de creuset permet de réduire le temps de mise en oeuvre du procédé selon l'invention. En effet, la mise en place d'une telle plaque sur le fond de la cavité d'un creuset est une opération aisée comparée à la réalisation d'un pavage de germes, ou chaque germe doit être disposé un à un sur le fond de la cavité.

Le rendement du procédé de solidification dirigée par reprise sur une telle plaque est ainsi amélioré par rapport à un procédé de reprise classique sur pavage de germes par un gain de temps de préparation des germes et par le gain de matière du recyclage du pavage de germes.

## Exemples

L'invention est à présent décrite au moyen des exemples suivants. Elle n'est bien évidemment pas limitée à ces seuls exemples.

### Exemple 1

Des germes monocristallins sont obtenus par découpe d'un lingot Cz de silicium monocristallin obtenu par le procédé de tirage Czochralski.

Le lingot choisi possède un diamètre de 9 pouces (228,6 mm) et une orientation <100> (à $\pm$ 0,5° près) suivant la direction de tirage Zc.

Le lingot Cz est ainsi découpé en germes de surface 20 x 20 mm$^2$ et d'épaisseur de 20 mm. La découpe est réalisée avec une rotation de 10° autour de l'axe T par rapport à une position référence de cubage 3 faces <100>.

Les germes prélevés sont placés au fond d'un creuset avec un pavage tel que représenté en figure 1. Un premier germe A est placé en fond de creuset. Des deuxième A', troisième A" et quatrième A''' germes, identiques au premier germe A sont prélevés tel quel du lingot Cz. Le deuxième germe A' subit par rapport au germe A, une rotation de 180° autour de l'axe X, et est placé au contact du premier germe A selon la direction Y. Le troisième germe A", subit par rapport au premier germe A, une rotation de 180° autour de l'axe Y et est placé au contact du premier germe A selon la direction X. Le quatrième germe A''' subit par rapport au deuxième germe A', une rotation de 180° autour de l'axe Y, et est placé au contact du deuxième germe A' selon la direction X.

En répétant cette succession d'opérations de rotation autour des axes X et Y sur des germes identiques au premier germe A, on obtient ainsi un pavage de germes recouvrant le fond du creuset.

Ainsi, le pavage de germes présente les caractéristiques suivantes :

- le joint entre deux germes contigus est un joint de flexion présentant une désorientation de 20°,
- le plus petit des angles entre une normale au joint séparant deux germes adjacents et les directions <111> de ces germes est égal à 44,7°,
- le plus petit des angles entre la direction de solidification Z et la direction <100> d'un germe est nul (0°),
- la distance de projection $l_i$ dans un plan perpendiculaire à la direction Z, de la plus grande dimension $d_i$ de chaque germe mesurée parmi les plans {111} et suivant les directions <110>, est égale à 24,4 mm.

## Référence

[Dash] DASH W.C., "Growth of silicon crystals free from dislocations", J. Appl. Phy., n°4, Vol. 30, p. 459-474, 1959.

## Revendications

1. Assemblage (5) organisé de monocristaux (10) de silicium adjacents configuré pour la solidification dirigée d'un lingot (90) selon une direction Z privilégiée de solidification, avec plus de 70 % en nombre des monocristaux de l'assemblage, dits « monocristaux orientés », observés sur une section perpendiculaire à la direction Z privilégiée de solidification étant tels que:

   a) la désorientation $\theta_d$ d'un monocristal orienté avec le ou les monocristaux orientés qui lui sont adjacents est supérieure à 8°,
   b) le plus petit $\alpha$ des angles entre une normale au joint (50) séparant un monocristal orienté d'un ou des monocristaux orientés adjacents et les directions <111> du ou des monocristaux orientés adjacents est supérieur à 4°,
   c) le plus petit $\beta$ des angles entre la direction Z privilégiée de solidification, et les directions <100> dudit monocristal orienté est inférieur à 25° et/ou le plus petit des angles entre la direction Z privilégiée de solidification et les directions <111> du monocristal orienté est inférieur à 10°, et
   d) la distance de projection $l_i$ dans un plan perpendiculaire à la direction Z privilégiée de solidification, de la plus grande dimension $d_i$ du monocristal orienté, mesurée parmi les plans {111} et suivant les directions <110>, est inférieure à 40 mm,

   les monocristaux orientés étant tels que le joint séparant un monocristal orienté d'un ou des monocristaux orientés adjacents est différent d'un joint proche d'un joint d'indice de coïncidence $\sum n$, avec $n$ choisi parmi les nombres 3, 5, 9, 11, 27, 51 et 59.

2. Assemblage selon la revendication 1, dans lequel le plus petit $\beta$ des angles entre la direction Z privilégiée de solidification, et les directions <100> dudit monocristal orienté est supérieur à 4°, de préférence est supérieur à 8°,

3. Assemblage selon l'une quelconque des revendications précédentes, dans lequel la distance de projection $l_i$ est inférieure à 25 mm.

4. Assemblage selon la revendication précédente, dans lequel la distance de projection $l_i$ est inférieure

à 20 mm, de préférence inférieure à 10 mm.

5. Assemblage selon l'une quelconque des revendications précédentes, dans lequel le joint entre deux monocristaux orientés est un joint symétrique.

6. Assemblage selon l'une quelconque des revendications précédentes, dans lequel le joint entre deux monocristaux orientés adjacents est un joint de flexion {100} ou un joint de torsion {100}, et la désorientation entre lesdits deux monocristaux orientés est supérieure à 8°.

7. Assemblage selon l'une quelconque des revendications précédentes, dans lequel le joint entre deux monocristaux orientés adjacents est un joint de torsion {110}, et la désorientation entre lesdits deux monocristaux est supérieure à 8°.

8. Assemblage selon l'une quelconque des revendications précédentes, dans lequel les monocristaux orientés sont de forme pavé droit.

9. Assemblage selon la revendication précédente, constitué de monocristaux orientés présentant une forme de barreaux (53) disposés unidirectionnellement les uns par rapport aux autres de manière contiguë, les axes longitudinaux des barreaux étant parallèles.

10. Assemblage selon la revendication précédente, dans lequel un barreau présente une longueur ($L_b$) supérieure à 300 mm.

11. Assemblage selon l'une quelconque des revendications précédentes, les monocristaux orientés étant disposés selon deux directions (X) et (Y) orthogonales et présentant des arêtes parallèles aux directions (X) ou (Y).

12. Assemblage selon la revendication précédente, les monocristaux orientés étant de section transverse carrée et de côté de préférence inférieur ou égal à 20 mm.

13. Assemblage selon l'une quelconques des revendications 11 et 12, réalisé à partir de monocristaux identiques avec deux monocristaux adjacents et alignés suivant la direction (X) étant images l'un de l'autre par un retournement d'axe (Y) et deux monocristaux adjacents et alignés selon la direction (Y) étant images l'un de l'autre par un retournement d'axe (X).

14. Assemblage selon l'une quelconque des revendications précédentes de type pavage, dans lequel au moins une partie, de préférence tous les monocristaux orientés sont disposés de manière contiguë et sont amovibles et définissent des germes du pavage.

15. Assemblage selon l'une quelconque des revendications 1 à 12 sous forme d'un bloc monolithique, dans lequel au moins une partie, de préférence tous les monocristaux orientés sont cohésifs et définissent les grains du bloc.

16. Procédé de solidification dirigée comportant les étapes successives suivantes :

i) placer un assemblage de monocristaux selon l'une quelconque des revendications précédentes sur le fond de la cavité destinée à recevoir du silicium en fusion d'un creuset, et

ii) procéder à la solidification dirigée de silicium par reprise sur germes selon une direction Z privilégiée de solidification normale à l'assemblage de monocristaux de façon à obtenir un lingot de silicium,

iii) optionnellement, débiter le lingot en briques de section équivalente à la dimension souhaitée des plaquettes puis scier les briques en plaquettes de 50 à 300 $\mu$m d'épaisseur et/ou découper le lingot ou une partie du lingot obtenu à l'étape ii) ou au moins une des briques selon une direction normale à la direction privilégiée de solidification du lingot de façon à obtenir une plaque ou un ensemble de plaques, de préférence d'épaisseur comprise entre 5 mm et 100 mm,

iv) optionnellement, reprendre le procédé à l'étape i), l'assemblage de monocristaux étant formé par la plaque ou l'ensemble de plaques obtenue(s) à l'étape iii).

17. Lingot de silicium obtenu par le procédé selon la revendication 16, dans lequel plus de 70 % en nombre des grains du lingot, dits « grains orientés », observés sur une section perpendiculaire à la direction Z privilégiée de solidification sont tels que:

a) la désorientation $\theta_d$ d'un grain orienté avec le ou les grains orientés qui lui sont adjacents est supérieure à 8°,

b) le plus petit $\alpha$ des angles entre une normale au joint (50) séparant un grain orienté d'un ou des grains orientés adjacents et les directions <111> du ou des grains orientés adjacents est supérieur à 4°,

c) le plus petit $\beta$ des angles entre la direction Z privilégiée de solidification, et les directions <100> dudit grain orienté est inférieur à 25° et/ou le plus petit des angles entre la direction Z privilégiée de solidification et les directions <111> du grain orienté est inférieur à 10°, et

d) la distance de projection $l_i$' dans un plan per-

pendiculaire à la direction Z privilégiée de solidification, de la plus grande dimension $d_i$ du grain orienté, mesurée parmi les plans {111} et suivant les directions <110>, est inférieure à 40 mm, de préférence inférieure à 25 mm, de préférence inférieure à 20 mm, de préférence inférieure à 10 mm.

18. Lingot de silicium selon la revendication précédente, dans lequel la densité moyenne de dislocations est inférieure à $10^6$ cm$^{-2}$ et/ou la densité de dislocations intra granulaires est inférieure à $10^5$ cm$^{-2}$.

19. Ensemble comportant un assemblage selon l'une quelconque des revendications 1 à 15 et un creuset utile pour la solidification dirigée par reprise d'un lingot de silicium, ledit creuset comportant un logement, destiné à recevoir du silicium en fusion, dont le fond est recouvert en tout ou partie par l'assemblage.

**Patentansprüche**

1. Organisierte Anordnung (5) von benachbarten Siliziumeinkristallen (10), die für die gerichtete Erstarrung eines Blockes (90) in einer bevorzugten Erstarrungsrichtung Z ausgelegt ist, wobei mehr als 70 % der Anzahl der Einkristalle der Anordnung, "orientierte Einkristalle" genannt, die in einem zu der bevorzugten Erstarrungsrichtung Z senkrechten Schnitt beobachtet werden, so beschaffen sind, dass:

a) die Orientierungsabweichung $\theta_d$ eines orientierten Einkristalls von dem oder den orientierten Einkristallen, die ihm benachbart sind, größer als 8° ist,
b) der kleinste Winkel $\alpha$ der Winkel zwischen einer Normalen zu der Grenzfläche (50), die einen orientierten Einkristall von einem oder den benachbarten orientierten Einkristallen trennt, und den Richtungen <111> des oder der benachbarten orientierten Einkristalle größer als 4° ist,
c) der kleinste Winkel $\beta$ der Winkel zwischen der bevorzugten Erstarrungsrichtung Z und den Richtungen <100> des orientierten Einkristalls kleiner als 25° ist, und/oder der kleinste der Winkel zwischen der bevorzugten Erstarrungsrichtung Z und den Richtungen <111> des orientierten Einkristalls kleiner als 10° ist, und
d) der Projektionsabstand $l_i$, in einer zu der bevorzugten Erstarrungsrichtung Z senkrechten Ebene, der größten Abmessung $d_i$ des orientierten Einkristalls, die in den Ebenen {111} und entlang der Richtungen <110> gemessen wird, kleiner als 40 mm ist,

wobei die orientierten Einkristalle so beschaffen sind, dass die Grenzfläche, die einen orientierten Einkristall von einem oder den benachbarten orientierten Einkristallen trennt, verschieden von einer Grenzfläche ist, die einer Grenzfläche mit Koinzidenzindex $\sum n$ nahe ist, wobei $n$ aus den Zahlen 3, 5, 9, 11, 27, 51 und 59 gewählt ist.

2. Anordnung nach Anspruch 1, wobei der kleinste Winkel $\beta$ der Winkel zwischen der bevorzugten Erstarrungsrichtung Z und den Richtungen <100> des orientierten Einkristalls größer als 4°, vorzugsweise größer als 8° ist.

3. Anordnung nach einem der vorhergehenden Ansprüche, wobei der Projektionsabstand $l_i$ kleiner als 25 mm ist.

4. Anordnung nach dem vorhergehenden Anspruch, wobei der Projektionsabstand $l_i$ kleiner als 20 mm, vorzugsweise kleiner als 10 mm ist.

5. Anordnung nach einem der vorhergehenden Ansprüche, wobei die Grenzfläche zwischen zwei orientierten Einkristallen eine symmetrische Grenzfläche ist.

6. Anordnung nach einem der vorhergehenden Ansprüche, wobei die Grenzfläche zwischen zwei benachbarten orientierten Einkristallen eine Kippgrenze {100} oder eine Drehgrenze {100} ist und die Orientierungsabweichung zwischen diesen zwei orientierten Einkristallen größer als 8° ist.

7. Anordnung nach einem der vorhergehenden Ansprüche, wobei die Grenzfläche zwischen zwei benachbarten orientierten Einkristallen eine Drehgrenze {110} ist und die Orientierungsabweichung zwischen diesen zwei Einkristallen größer als 8° ist.

8. Anordnung nach einem der vorhergehenden Ansprüche, wobei die orientierten Einkristalle quaderförmig sind.

9. Anordnung nach dem vorhergehenden Anspruch, welche aus orientierten Einkristallen besteht, welche eine Form von Stäben (53) aufweisen, welche zueinander unidirektional und aneinandergrenzend angeordnet sind, wobei die Längsachsen der Stäbe parallel sind.

10. Anordnung nach dem vorhergehenden Anspruch, wobei ein Stab eine Länge ($L_b$) aufweist, die größer als 300 mm ist.

11. Anordnung nach einem der vorhergehenden Ansprüche, wobei die orientierten Einkristalle in zwei orthogonalen Richtungen (X) und (Y) angeordnet sind und Kanten aufweisen, die zu den Richtungen (X) oder (Y) parallel sind.

12. Anordnung nach dem vorhergehenden Anspruch, wobei die orientierten Einkristalle einen quadratischen Querschnitt mit einer Seitenlänge, die vorzugsweise kleiner oder gleich 20 mm ist, aufweisen.

13. Anordnung nach einem der Ansprüche 11 und 12, die aus identischen Einkristallen hergestellt sind, wobei zwei in der Richtung (X) benachbarte und fluchtende Einkristalle Abbildungen voneinander sind, die durch eine Drehung um die Achse (Y) erhalten werden, und zwei in der Richtung (Y) benachbarte und fluchtende Einkristalle Abbildungen voneinander sind, die durch eine Drehung um die Achse (X) erhalten werden.

14. Anordnung nach einem der vorhergehenden Ansprüche vom Typ einer Pflasterung, wobei wenigstens ein Teil der orientierten Einkristalle und vorzugsweise alle aneinandergrenzend angeordnet sind und lösbar sind und Keime der Pflasterung definieren.

15. Anordnung nach einem der Ansprüche 1 bis 12 in Form eines monolithischen Blocks, wobei wenigstens ein Teil der orientierten Einkristalle und vorzugsweise alle kohäsiv sind und die Körner des Blocks definieren.

16. Verfahren zur gerichteten Erstarrung, welches die folgenden aufeinander folgenden Schritte umfasst:

i) Positionieren einer Anordnung von Einkristallen nach einem der vorhergehenden Ansprüche auf dem Boden des zur Aufnahme von geschmolzenem Silizium bestimmten Hohlraums eines Tiegels, und

ii) Durchführen der gerichteten Erstarrung von Silizium durch Wachstum auf Keimen in einer bevorzugten Erstarrungsrichtung Z, die zu der Anordnung von Einkristallen senkrecht ist, um einen Siliziumblock zu erhalten,

iii) optional, Zerlegen des Blocks in Teilstücke mit einem Querschnitt, der zu der gewünschten Abmessung der Platten äquivalent ist, danach Zersägen der Teilstücke in Platten von 50 bis 300 μm Dicke, und/oder Zerschneiden des Blocks oder eines Teils des Blocks, der in Schritt ii) erhalten wurde, oder wenigstens eines der Teilstücke in einer Richtung, die zu der bevorzugten Erstarrungsrichtung des Blocks senkrecht ist, um eine Platte oder eine Menge von Platten zu erhalten, vorzugsweise mit einer Dicke zwischen 5 mm und 100 mm,

iv) optional, erneutes Ausführen des Verfahrens ab Schritt i), wobei die Anordnung von Einkristallen von der Platte oder der Menge von Platten gebildet wird, die in Schritt iii) erhalten wurde(n).

17. Siliziumblock, welcher durch das Verfahren nach Anspruch 16 erhalten wurde, wobei mehr als 70 % der Anzahl der Körner des Blocks, "orientierte Körner" genannt, die in einem zu der bevorzugten Erstarrungsrichtung Z senkrechten Schnitt beobachtet werden, so beschaffen sind, dass:

a) die Orientierungsabweichung $\theta_d$ eines orientierten Korns von dem oder den orientierten Körnern, die ihm benachbart sind, größer als 8° ist,
b) der kleinste Winkel $\alpha$ der Winkel zwischen einer Normalen zu der Grenzfläche (50), die ein orientiertes Korn von einem oder den benachbarten orientierten Körnern trennt, und den Richtungen <111> des oder der benachbarten orientierten Körner größer als 4° ist,
c) der kleinste Winkel $\beta$ der Winkel zwischen der bevorzugten Erstarrungsrichtung Z und den Richtungen <100> des orientierten Korns kleiner als 25° ist, und/oder der kleinste der Winkel zwischen der bevorzugten Erstarrungsrichtung Z und den Richtungen <111> des orientierten Korns kleiner als 10° ist, und
d) der Projektionsabstand $l_i'$, in einer zu der bevorzugten Erstarrungsrichtung Z senkrechten Ebene, der größten Abmessung $d_i$ des orientierten Korns, die in den Ebenen {111} und entlang der Richtungen <110> gemessen wird, kleiner als 40 mm, vorzugsweise kleiner als 25 mm, vorzugsweise kleiner als 20 mm, vorzugsweise kleiner als 10 mm ist.

18. Siliziumblock nach dem vorhergehenden Anspruch, wobei die mittlere Versetzungsdichte kleiner als $10^6$ cm$^{-2}$ ist und/oder die Dichte intragranularer Versetzungen kleiner als $10^5$ cm$^{-2}$ ist.

19. Gesamtheit, welche eine Anordnung nach einem der Ansprüche 1 bis 15 und einen Tiegel, der für die gerichtete Erstarrung eines Siliziumblocks durch Aufwachsen verwendbar ist, umfasst, wobei der Tiegel eine Aufnahme aufweist, die dazu bestimmt ist, geschmolzenes Silizium aufzunehmen, und deren Boden ganz oder teilweise von der Anordnung bedeckt ist.

**Claims**

1. Organized assembly (5) of adjacent silicon single crystals (10) configured for the directional solidification of an ingot (90) along a favoured solidification direction Z, with more than 70% by number of the single crystals of the assembly, referred to as "oriented single crystals", observed over a section perpendicular to the favoured solidification direction Z being such that:

a) the misorientation $\theta_d$ of an oriented single crystal with the oriented single crystal or crystals that are adjacent thereto is greater than 8°,
b) the smallest $\alpha$ of the angles between a normal to the boundary (50) separating an oriented single crystal from one or some adjacent oriented single crystals and the directions <111> of the adjacent oriented single crystal(s) is greater than 4°,
c) the smallest $\beta$ of the angles between the favoured solidification direction Z and the directions <100> of said oriented single crystal is less than 25° and/or the smallest of the angles between the favoured solidification direction Z and the directions <111> of the oriented single crystal is less than 10°, and
d) the projection distance $l_i$ in a plane perpendicular to the favoured solidification direction Z, of the largest dimension $d_i$ of the oriented single crystal, measured among the planes {111} and along the directions <110>, is less than 40 mm,

the oriented single crystals being such that the boundary separating one oriented single-crystal from one or some adjacent oriented single crystals is different from a boundary close to a boundary having a coincidence index $\Sigma n$, with $n$ chosen from the numbers 3, 5, 9, 11, 27, 51 and 59.

2.  Assembly according to Claim 1, in which the smallest $\beta$ of the angles between the favoured solidification direction Z and the directions <100> of said oriented single crystal is greater than 4°, preferably is greater than 8°.

3.  Assembly according to either one of the preceding claims, in which the projection distance $l_i$ is less than 25 mm.

4.  Assembly according to the preceding claim, in which the projection distance $l_i$ is less than 20 mm, preferably less than 10 mm.

5.  Assembly according to any one of the preceding claims, in which the boundary between two oriented single crystals is a symmetrical boundary.

6.  Assembly according to any one of the preceding claims, in which the boundary between two adjacent oriented single crystals is a tilt boundary {100} or a twist boundary {100}, and the misorientation between said two oriented single crystals is greater than 8°.

7.  Assembly according to any one of the preceding claims, in which the boundary between two adjacent oriented single crystals is a twist boundary {110}, and the misorientation between said two single crystals is greater than 8°.

8.  Assembly according to any one of the preceding claims, in which the oriented single crystals are of rectangular cuboid shape.

9.  Assembly according to the preceding claim, consisting of oriented single crystals having a shape of bars (53) positioned unidirectionally with respect to one another in a contiguous manner, the longitudinal axes of the bars being parallel.

10. Assembly according to the preceding claim, in which a bar has a length ($L_b$) of greater than 300 mm.

11. Assembly according to any one of the preceding claims, the oriented single crystals being positioned along two orthogonal directions (X) and (Y) and having edges parallel to the directions (X) or (Y).

12. Assembly according to the preceding claim, the oriented single crystals being of square cross section and having a side preferably of less than or equal to 20 mm.

13. Assembly according to either one of Claims 11 and 12, produced from identical single crystals with two adjacent single crystals that are aligned along the direction (X) being images of one another by a turning over in axis (Y) and two adjacent single crystals that are aligned along the direction (Y) being images of one another by a turning over in axis (X).

14. Assembly according to any one of the preceding claims of tiling type, in which at least some, preferably all of the oriented single crystals are positioned in a contiguous manner and are removable and define seeds of the tiling.

15. Assembly according to any one of Claims 1 to 12 in the form of a monolithic block, in which at least some, preferably all of the oriented single crystals are cohesive and define the grains of the block.

16. Directional solidification process comprising the following successive steps:

i) placing an assembly of single crystals according to any one of the preceding claims on the bottom of the cavity intended to receive molten silicon of a crucible, and
ii) carrying out the directional solidification of silicon by seeded regrowth along a favoured solidification direction Z normal to the assembly of single crystals so as to obtain a silicon ingot,

iii) optionally, slicing the ingot into bricks having a section equivalent to the desired dimension of the wafers, then sawing the bricks into wafers with a thickness of 50 to 300 $\mu$m and/or cutting the ingot or a portion of the ingot obtained in step ii) or at least one of the bricks along a direction normal to the favoured solidification direction of the ingot so as to obtain a sheet or a set of sheets, preferably having a thickness of between 5 mm and 100 mm,

iv) optionally, repeating the process in step i), the assembly of single crystals being formed by the sheet or set of sheets obtained in step iii).

17. Silicon ingot obtained by the process according to Claim 16, in which more than 70% by number of the grains of the ingot, referred to as "oriented grains", observed over a section perpendicular to the favoured solidification direction Z are such that:

a) the misorientation $\theta_d$ of an oriented grain with the oriented grain or grains that are adjacent thereto is greater than 8°,

b) the smallest $\alpha$ of the angles between a normal to the boundary (50) separating an oriented grain from one or some adjacent oriented grains and the directions <111> of the adjacent oriented grain(s) is greater than 4°,

c) the smallest $\beta$ of the angles between the favoured solidification direction Z and the directions <100> of said oriented grain is less than 25° and/or the smallest of the angles between the favoured solidification direction Z and the directions <111> of the oriented grain is less than 10°, and

d) the projection distance $l_i'$ in a plane perpendicular to the favoured solidification direction Z, of the largest dimension $d_i$ of the oriented grain, measured among the planes {111} and along the directions <110>, is less than 40 mm, preferably less than 25 mm, preferably less than 20 mm, preferably less than 10 mm.

18. Silicon ingot according to the preceding claim, in which the mean density of dislocations is less than $10^6$ cm$^{-2}$ and/or the density of intra-granular dislocations is less than $10^5$ cm$^{-2}$.

19. Set comprising an assembly according to any one of Claims 1 to 15 and a crucible of use for the directional solidification by regrowth of a silicon ingot, said crucible comprising a housing, intended to receive molten silicon, the bottom of which is covered completely or partly by the assembly.

Fig.1

Fig.2

Fig.3

Fig.4

Fig.5

Fig.6

**Fig.7**

**Fig.8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 102011086669 A1

**Littérature non-brevet citée dans la description**

- **K. KUTSUKAKE et al.** Influence ofstructural imperfection of ∑5 grain boundaries in bulk multicrystalline Si on their electrical activities. *Journal of Applied Physics,* 2007, vol. 101, 063509

- **DASH W.C.** Growth of silicon crystals free from dislocations. *J. Appl. Phy.,* 1959, vol. 30 (4), 459-474